# EUROPEAN PATENT APPLICATION

(11) **EP 3 758 137 A1**
(43) Date of publication of application: **30.12.2020**
(21) Application number: 19183316.9
(22) Date of filing: 28.06.2019
(51) Int. Cl.: H01P 5/103, H01P 5/107, H05K 3/46, B33Y 80/00, B33Y 10/00, H01P 11/00

(54) **STRUCTURE AND METHOD OF MANUFACTURING A STRUCTURE FOR GUIDING ELECTROMAGNETIC WAVES**

(71) Applicant: Nokia Solutions and Networks Oy, 02610 Espoo (FI)
(72) Inventor: Pivit, Florian, DUBLIN, 20 (IE); Bulja, Senad, Dublin, 15 (IE)
(74) Representative: DREISS Patentanwälte PartG mbB

(57) **Abstract**

Structure and method of manufacturing a structure for guiding electromagnetic waves, the method comprising providing a printed circuit board having a conductive trace, and providing a metal structure on the conductive trace for guiding the electromagnetic waves, wherein the conductive trace is disposed on the printed circuit board, wherein a metal powder is disposed on the conductive trace, and the metal structure is printed onto the conductive trace on the printed circuit board by fusion using laser.

## Description

### Field of the invention

The description relates to a structure and a method of manufacturing a structure for guiding electromagnetic waves.

### Background

Some structures for guiding electromagnetic waves require soldering, brazing, or mechanical means for connecting parts of the structure.

### Summary

A method of manufacturing a structure for guiding electromagnetic waves, the method comprising providing a printed circuit board having a conductive trace, and providing a metal structure on the conductive trace for guiding the electromagnetic waves, wherein the conductive trace is disposed on the printed circuit board, wherein a metal powder is disposed on the conductive trace, and the metal structure is printed onto the conductive trace on the printed circuit board by fusion using laser. This provides an integration of a three-dimensional laser printed metal structure onto the trace of the printed circuit board. Integration in this context refers to a fusion between the trace metal and the powdered metal, thus creating an alloy between the two metals.

In one aspect, the method comprises providing the conductive trace on the printed circuit board with a cross section having a shape and printing the metal structure having a cross section of the same shape as the conductive trace.

In one aspect the method comprises providing a conductive trace surrounding a non-conductive area of the printed circuit board at least partially, and printing a metal structure having a hollow space therein onto the conductive trace.

In another aspect, the method comprises providing an outer conductive trace surrounding an inner conductive trace at least partially, wherein the outer conductive trace and the inner conductive trace are spaced apart by a non-conductive area of the printed circuit board, and printing an outer metal structure onto the outer conductive trace, and printing an inner metal structure onto the inner conductive trace. The inner conductive trace may be formed as part of a microstrip line on the printed circuit board to which the inner metal structure forming a core of the wave guide connects. The outer conductive trace may be formed as ground connector for the outer metal structure forming an outer wall of the wave guide. This means the metal structure forms a TEM wave guide.

In another aspect, the electromagnetic wave has a wavelength, the method comprises printing the metal structure having a wall thickness being a fraction of said wavelength.

Preferably, the wavelength is in a range between 0.1 millimeter and 10 millimeters. The preferred wavelength for millimeter radio structures is in the range between 1 millimeter and 10 millimeters. When the metal structure is printed as wave guide for electromagnetic waves for a specific millimeter radio structure having a certain wavelength, the wall is printed with a wall thickness having a fraction of this wavelength.

The method may comprise providing the printed circuit board with a via electrically connecting the conductive trace with another conductive trace on an opposite side of the printed circuit board. This way a ground via for the wave guide is provided.

The method may comprise providing the printed circuit board having the conductive trace, disposing an adhesive layer onto the conductive trace, and printing the structure onto the adhesive layer. The adhesive layer may be a bonding layer. The terms adhesive and bonding refer to a fusion between the trace metal and the powdered metal, thus creating an alloy between the two metals or to a fusion between the adhesive layer metal and the powdered metal, thus creating an alloy between the two metals. Disposing the adhesive layer may refer to adhering or bonding the adhesive layer onto the conductive trace.

A structure for guiding electromagnetic waves, comprises a printed circuit board having a conductive trace, and a metal structure for guiding the electromagnetic waves on the conductive trace, wherein the metal structure is integrally formed on the conductive trace disposed on the printed circuit board or wherein the metal structure is integrally formed on an adhesive layer formed on the conductive trace disposed on the printed circuit board.

In one aspect, the conductive trace has a cross section having a shape and the metal structure has a cross section of the same shape as the conductive trace. These shapes are preferred for forming wave guides.

In another aspect, the electromagnetic wave has a wavelength, wherein the metal structure may have a wall thickness being a fraction of said wavelength.

Preferably, the wall thickness is in a range between 0.1 millimeter and 10 millimeters.

### Brief description of the figures

Further features, aspects and advantages of examples of the illustrative embodiments are explained in the following detailed description with reference to the drawings in which:
- Figure 1a, 1b: schematically depict aspects of a laser sintering process,
- Figure 2: schematically depicts aspects of another laser sintering process,
- Figure 3: schematically depicts aspects related to a wave guide in a first view,
- Figure 4: schematically depicts aspects related to another wave guide in a second view,
- Figure 5: schematically depicts aspects related to a plurality of wave guides in a third view,
- Figure 6: schematically depicts a perspective view of aspects related to a wave guide.

### Detailed description of illustrative embodiments

One of the major challenges of integrating printed circuit board structures with other forms of structures such as rectangular waveguides or TEM-type waveguides is that especially at higher frequencies they typically require expensive forms of doing so, such as screwed connectors, precision-alignment, or soldering of connectors.

Strip line-Coax transition may be used for connecting but this typically requires a connector that is soldered or clamped onto the edge of the printed circuit board. This connector can be very large in comparison to the waveguide itself, especially higher frequencies. This may inhibit close integration of many of such transitions close to each other. Also this transition typically requires the line being led to the edge of the printed circuit board and is hard to apply in the central region of a printed circuit board.

Stripline-waveguide transition may be used especially for millimeter wave frequencies. For millimeter waves rectangular waveguides are very popular, because they allow for very low loss, but the transition between a waveguided wave and a strip line guided wave is often very cumbersome to realize. The connection typically requires several precision-machined parts to be assembled by screws, alignment holes and the printed circuit board itself. This may be a very real-estate consuming solution, expensive and may not allow for tight integration. Especially for multiple of such assemblies right next to each other.

In contrast to this a manufacturing and integration methodology for a direct integration of the printed circuit structure with the 3D-waveguide structure itself is proposed. By using, e.g. 3D laser-sintered printing, this integration is achieved without further steps such as screws, bolts, soldering, or gluing.

In some printed circuit board technology, a metallization layer on the printed circuit board is made from copper. Copper is a material that is very reflective to (esp. C02-)laser light. Hence, such metallization layers made of copper are typically not suited for fusion by laser in 3D-laser printing.

In the following examples methods of manufacturing a structure for guiding electromagnetic waves and resulting structures are described. Aspects of the following description relate to first applying a metal powder, like aluminium powder, onto the metallization layer on the printed circuit board and then bonding the metal powder to the metallization layer by fusion using a laser. Other aspects relate to first applying onto the metallisation layer an adhesion layer from other metals that bond easier with both copper and the metal powder, such as silver, then applying the metal powder and then bonding the metal powder onto the adhesion layer by fusion using laser.

The fusion using laser provides an integration of a three-dimensional laser printed metal structure onto the trace of the printed circuit board. This fusion between the trace metal and the powdered metal or between the adhesive layer metal and the powdered metal allows manufacturing of the wave guide and printed circuit board components in a size of a fraction of a wavelength.

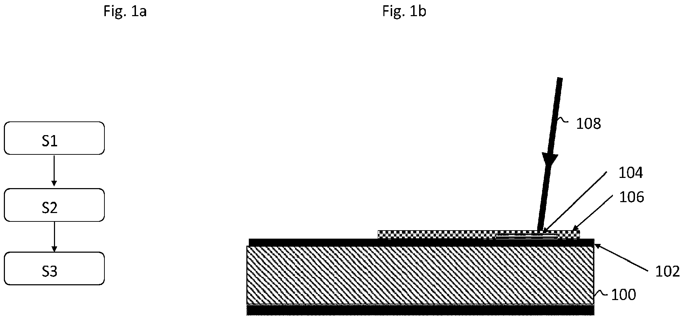

An exemplary method is described referencing Figure 1a and Figure 1b. The method comprises a step S1 of providing a printed circuit board 100 having a conductive trace 102, a step S2 of providing a metal powder 106 on the conductive trace 102, and a step S3 of fusing or curing a metal structure 104.

In the example depicted in Figure 1a and 1b, the metal structure 104 is printed onto the conductive trace 102 disposed on the printed circuit board 100 in a laser sinter process.

The laser sinter process comprises providing a metal powder layer 106 onto the conductive trace 102 and fusing the metal powder layer 106 onto the conductive trace 102 using a laser beam 108 for sintering of the metal powder in the metal powder layer 106.

The laser beam 108 is preferably guided to sinter the metal powder where the conductive trace 102 is disposed. The laser beam 108 may be guided to follow the shape of the conductive trace 102 facing the laser beam 108 in order to sinter the metal powder only where the conductive trace 102 is disposed.

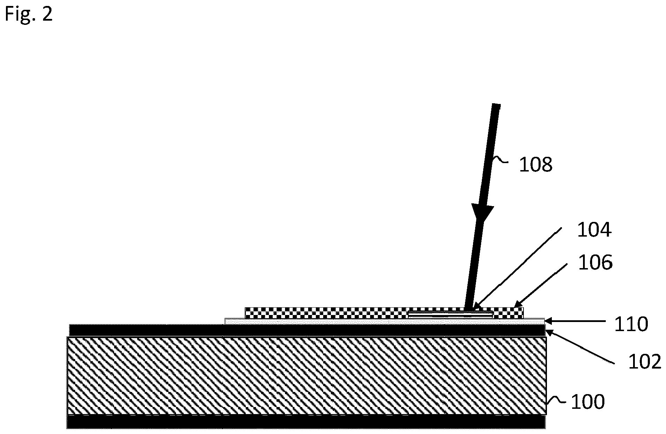

In one aspect depicted in Figure 2, the method may comprise providing the printed circuit board 100 having the conductive trace 102, disposing an adhesive layer 110 onto the conductive trace 102, and printing the metal structure 104 onto the adhesive layer 110. The laser sinter process may be used for printing. The laser sinter process may comprise providing a metal powder layer 106 onto the adhesive layer 110 and fusing the metal powder layer 106 onto the adhesive layer 110 using a laser beam 108 for sintering of the metal powder in the metal powder layer 106. The laser beam 108 is preferably guided to sinter the metal powder where the adhesive layer 110 is disposed. The laser beam 108 may be guided to follow the shape of the adhesive layer 110 facing the laser beam 108 in order to sinter the metal powder only where the adhesive layer 110 is disposed. The adhesive layer 110 may be disposed where the conductive trace 102 is disposed so that the metal structure 104 is printed only where the conductive trace 102 is disposed. The laser beam 108 may be guided to follow the shape of the conductive trace 102 facing the laser beam 108 in order to sinter the metal powder onto the adhesive layer 110 only where the conductive trace 102 is disposed.

In 3D sintered laser printing thin layers of metal powder are sintered or fused with a laser beam into solid metal. This is repeated in a layer-by-layer manner until the desired structure is created. A base-layer to be constructed for this process is created by printed circuit board technology. Then a first 3D-laser-sinter-printed layer is fused on top of the resulting metallization layer. The metallization layer on the printed circuit board may be made from copper. Copper is a material that is very reflective and not suited to fuse with metals like aluminum that are usually used for 3D-laser printing. The adhesion layer is therefore applied from other metals that bond easier with both copper and the metal powder. The adhesion layer is for example created using silver.

The terms adhesive and bonding may be regarded to have the same meaning and refer to a fusion between the trace metal and the powdered metal, thus creating an alloy between the two metals of the metal structure 104 and the conductive trace 102 or the adhesive layer 110.

In another example, a laser curing process may be used instead of the laser sintering process. In this aspect a liquid carrier for the metal may be disposed instead of disposing the metal powder.

A laser, in particular a CO2 laser may be used to produce the laser beam 108.

This provides an integration of a three-dimensional laser printed metal structure 104 onto the printed circuit board 100. Integration in this context refers to a fusion between the trace metal and the powdered metal, thus creating an alloy between the two metals.

Applying a plurality of layers, a three-dimensional shape extending from the printed circuit board 100 is created.

In one aspect, the conductive trace 102 is provided on the printed circuit board 100 with a cross section having a shape. The shape for example is a tube shape or a rectangular shape In this aspect the metal structure 104 is printed having a cross section of the same shape as the conductive trace 102. The optional adhesive layer 110 may have a cross section of the same shape of the conductive trace 102 and/or of the metal structure 104. Preferably the dimensions of the cross sections match.

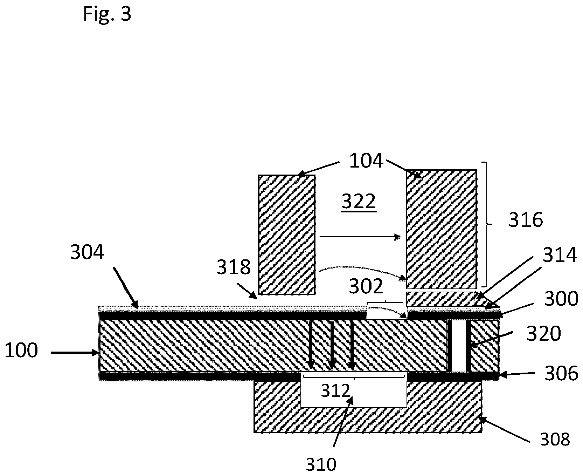

Figure 3 depicts a side view of a structure. For manufacturing the structure according to the aspect depicted in Figure 3, a first conductive trace 300 is provided that surrounds a non-conductive area 302 of the printed circuit board 100 at least partially. In this aspect a metal structure 104 is printed onto the conductive trace 102. At the side of the printed circuit board 100 opposite to the first conductive trace 300 and the second conductive trace 304, a third conductive trace 306 may be disposed. The third conductive trace 306 may be formed integrally with another metal structure 308 by laser sintering or laser curing. The third conductive trace 306 and the other metal structure 308 are disposed to form a cavity 310 between the third conductive trace 306 and the printed circuit board 100 in a non-conductive area 312.

In this aspect the method comprises providing the printed circuit board 102 with the first conductive trace 300 and the second conductive trace 304. An optional adhesive layer may be disposed on the first conductive trace 300. The second conductive trace 304 is electrically isolated from the first conductive trace 300. The second conductive trace 304 may be provided as a microstrip line. According to this aspect, a plurality of first layers 314 is printed onto the first conductive trace 300 having an open shape and a plurality of second layers 316 is printed onto the plurality of first layers 314 having a closed shape to form the metal structure 104 with a hollow space 322 therein.

The first conductive trace 300 and the plurality of first layers 314 comprise a recess 318 for the second conductive trace 304. The first layers 314 are printed for example in U shape. The second layers 316 are printed for example in O shape.

In the example a via hole 320 is provided in the printed circuit board 100 that electrically connects the first conductive trace 300 to the third conductive trace 306. This way a ground via for the wave guide is provided.

This means that a hollow wave guide is provided with an opening near the printed circuit board in an area where a microstrip line runs. In this manner, the metal structure 104 forms a TE wave guide.

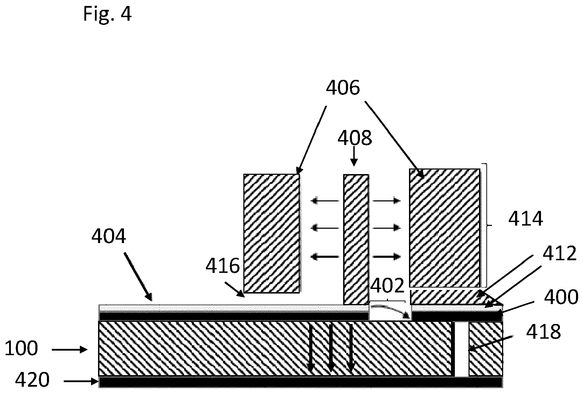

Figure 4 depicts a side view of another structure. For manufacturing the structure according to the aspect depicted in Figure 4, an outer conductive trace 400 is provided surrounding a non-conductive area 402 of the printed circuit board 100 and an inner conductive trace 404 at least partially. The outer conductive trace 400 and the inner conductive trace 404 are spaced apart by the non-conductive area 402 of the printed circuit board 100. The outer conductive trace 400 and the inner conductive trace 404 are electrically isolated from each other. An outer metal structure 406 is printed onto the outer conductive trace 400, and an inner metal structure 408 is printed onto the inner conductive trace 404. The inner conductive trace 404 may be formed as part of a microstrip line on the printed circuit board 100 to which the inner metal structure 408 forming a core of the wave guide connects. The outer conductive trace 400 may be formed as ground connector for the outer metal structure 406 forming an outer wall of the wave guide. This means the metal structure forms a TEM wave guide.

In this aspect, the inner metal structure 408 and the outer metal structure 406 may be disposed coaxially. Hence, the wave guide may be formed as a coaxial wave guide.

In this aspect the outer conductive trace 400 and the inner conductive trace 404 may be disposed coaxially. Hence, a coaxial wave guide may be manufactured efficiently.

A plurality of first layers 410 may be printed onto the first conductive trace 400 and a plurality of second layers 414 may be printed onto the plurality of first layers 412 to form the hollow outer metal structure 406.

The first conductive trace 400 and the plurality of first layers 412 may comprise a recess 416 for the second conductive trace 404. The first layers 412 are printed for example in U shape. The second layers 414 are printed for example in O shape.

The printed circuit board 100 may be provided with a via 418 electrically connecting the first conductive trace 400 with a third conductive trace 420 on an opposite side of the printed circuit board 100. This way a ground via for the wave guide is provided.

The metal structures described above may be printed having a wall thickness in a range between 0.1 millimeter and 10 millimeters. The metal structure is preferably printed as a wave guide having a wall thickness of a fraction of a wavelength of an electromagnetic wave it is designed to guide. The wavelength for millimeter radio is a wavelength in the range between 1 millimeter and 10 millimeters. The diameter of a cross-sectional area of the hollow inside the metal structures described is in the dimension of one wavelength.

The conductive traces described above may be provided, for example, with one of copper, titanium, aluminum or silver.

Where the adhesive layer 110 is present or provided, the conductive trace may be a copper trace and the adhesive layer may be one of a titanium, an aluminum or a silver layer. _Titanium, aluminum or silver are preferred because these metals bond easier onto the copper traces.

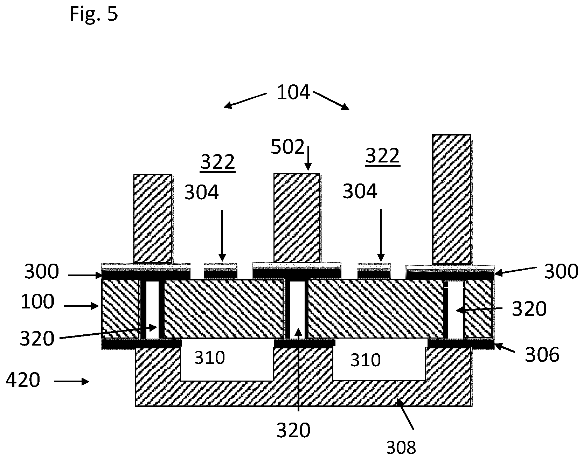

Figure 5 schematically depicts aspects related to a plurality of wave guides of the TE type that has been described above with reference to Figure 3. Like elements are referenced in Figure 5 with the same reference numeral as in Figure 3 and not described again.

This structure comprises a plurality of metal structures 104 with the hollow space 322 therein. Neighboring metal structures 104 share a common wall 502. This structure comprises a plurality of second conductive traces 304. This structure comprises a plurality of via holes 320 connecting walls of the metal structure 104 to the third conductive trace 306.

Due to the three-dimensional printing the wall dimensions of fractions of the wavelength for millimeter radio are easily manufactured onto the first conductive traces 300 of the printed circuit board 100 between the microstrip lines formed by the second conductive traces 304.

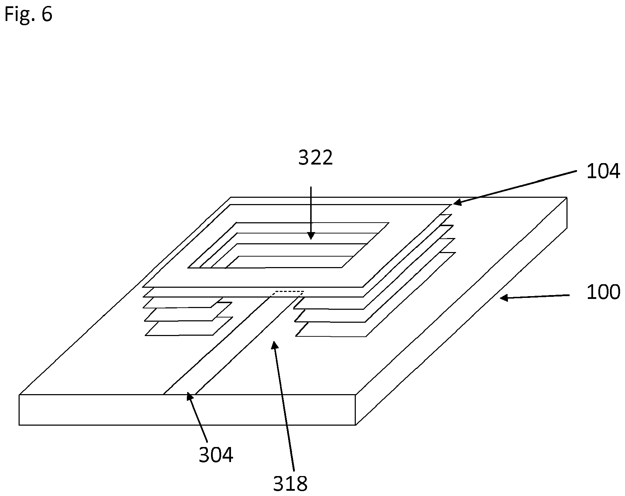

Figure 6 schematically depicts a perspective view of aspects related to a plurality of wave guides of the TE type that has been described above with reference to Figure 3. Like elements are referenced in Figure 6 with the same reference numeral as in Figure 3 and not described again.

The structure comprises the metal structures 104 with the recess 318 and the hollow space 322 therein. The second conductive trace 304 is printed on the printed circuit board 100 where the recess 318 and the hollow space 322 are formed in the metal structure 104.

## Claims

1. A method of manufacturing a structure for guiding electromagnetic waves, the method comprising providing a printed circuit board having a conductive trace, and providing a metal structure on the conductive trace for guiding the electromagnetic waves, wherein the conductive trace is disposed on the printed circuit board, wherein a metal powder is disposed on the conductive trace, and the metal structure is printed onto the conductive trace on the printed circuit board by fusion using laser.

2. The method according to claim 1, comprising providing the conductive trace on the printed circuit board with a cross section having a shape and printing the metal structure having a cross section of the same shape as the conductive trace.

3. The method according to one of the previous claims, comprising providing a conductive trace surrounding a non-conductive area of the printed circuit board at least partially, and printing a metal structure having a hollow space therein onto the conductive trace.

4. The method according to one of the previous claims, comprising providing an outer conductive trace surrounding an inner conductive trace at least partially, wherein the outer conductive trace and the inner conductive trace are spaced apart by a non-conductive area of the printed circuit board, and printing an outer metal structure onto the outer conductive trace, and printing an inner metal structure onto the inner conductive trace.

5. The method according to one of the previous claims, wherein the electromagnetic wave has a wavelength, the method comprising printing the metal structure having a wall thickness being a fraction of said wavelength.

6. The method according to claim 5, wherein the wavelength is in a range between 0.1 millimeter and 10 millimeters.

7. The method according to one of the previous claims, wherein the printed circuit board is provided with a via electrically connecting the conductive trace with another conductive trace on an opposite side of the printed circuit board.

8. The method according to one of the previous claims, comprising providing the printed circuit board having the conductive trace, disposing an adhesive layer onto the conductive trace, and printing the structure onto the adhesive layer.

9. Structure for guiding electromagnetic waves, comprising a printed circuit board having a conductive trace, and a metal structure for guiding the electromagnetic waves on the conductive trace, wherein the metal structure is integrally formed on the conductive trace disposed on the printed circuit board.

10. The structure according to claim 9, wherein the metal structure is integrally formed on an adhesive layer formed on the conductive trace disposed on the printed circuit board.

11. The structure according to claim 10, wherein the conductive trace has a cross section having a shape and wherein the metal structure has a cross section of the same shape as the conductive trace.

12. The structure according to one of the claims 9 to 11, wherein the electromagnetic wave has a wavelength, wherein the metal structure has a wall thickness being a fraction of said wavelength.

13. The structure according to claim 12, wherein the wall thickness is in a range between 0.1 millimeter and 10 millimeters.

## Amended claims

### Amended claims in accordance with Rule 137(2) EPC.

1. A method of manufacturing a structure for guiding electromagnetic waves in a hollow 3D-waveguide structure, the method comprising providing a printed circuit board (100) having a conductive trace (102), and providing a metal structure on the conductive trace (102) for guiding the electromagnetic waves, wherein the conductive trace (102) is disposed on the printed circuit board (100), wherein a metal powder (106) is disposed on the conductive trace (102), and the metal structure (104) is printed onto the conductive trace (102) on the printed circuit board (100) by fusion of the metal power using a laser, wherein the printed circuit board (100) is provided with a via (418) electrically connecting the conductive trace (300; 400, 404) with another conductive trace (306) on an opposite side of the printed circuit board (100), wherein the other conductive trace (306) and another metal structure (308) are disposed to form a cavity (310) between the other conductive trace (306) and the printed circuit board (100) in a non-conductive area (312).

2. The method according to claim 1, comprising providing the conductive trace (102) on the printed circuit board (100) with a cross section having a shape and printing the metal structure (104) having a cross section of the same shape as the conductive trace (102) .

3. The method according to one of the previous claims, comprising providing the conductive trace (300, 304) surrounding a non-conductive area (302) of the printed circuit board (100) at least partially, and printing a metal structure (104) having a hollow space (322) therein onto the conductive trace (102).

4. The method according to one of the previous claims, comprising providing an outer conductive trace (400) surrounding an inner conductive trace (404) at least partially, wherein the outer conductive trace (400) and the inner conductive trace (404) are spaced apart by a non-conductive area (302) of the printed circuit board (100), and printing an outer metal structure (404) onto the outer conductive trace (400), and printing an inner metal structure (104) onto the inner conductive trace (404).

5. The method according to one of the previous claims, wherein the electromagnetic wave has a wavelength, the method comprising printing the metal structure (104) having a wall thickness being a fraction of said wavelength.

6. The method according to claim 5, wherein the wavelength is in a range between 0.1 millimeter and 10 millimeters.

7. The method according to one of the previous claims, comprising providing the printed circuit board (100) having the conductive trace (102), disposing an adhesive layer (110) onto the conductive trace (102), and printing the structure onto the adhesive layer (110) .

8. Structure for guiding electromagnetic waves in a hollow 3D-waveguide structure, comprising a printed circuit board (100) having a conductive trace (102), and a metal structure (104) for guiding the electromagnetic waves on the conductive trace (102), wherein the metal structure (104) is integrally formed on the conductive trace (102) disposed on the printed circuit board (100) and the metal structure (104) is printed onto the conductive trace (102) or an adhesive layer (110) on the printed circuit board (100) by fusion of a metal powder using a laser, wherein the printed circuit board (100) is provided with a via (418) electrically connecting the conductive trace (300; 400, 404) with another conductive trace (306) on an opposite side of the printed circuit board (100), wherein the other conductive trace (306) and another metal structure (308) are disposed to form a cavity (310) between the other conductive trace (306) and the printed circuit board (100) in a non-conductive area (312).

9. The structure according to claim 8, wherein the metal structure (104) is integrally formed on an adhesive layer (110) formed on the conductive trace disposed on the printed circuit board (100).

10. The structure according to claim 9, wherein the conductive trace (102) has a cross section having a shape and wherein the metal structure (104) has a cross section of the same shape as the conductive trace (102).

11. The structure according to one of the claims 8 to 10, wherein the electromagnetic wave has a wavelength, wherein the metal structure (104) has a wall thickness being a fraction of said wavelength.

12. The structure according to claim 11, wherein the wall thickness is in a range between 0.1 millimeter and 10 millimeters.
